# EUROPEAN PATENT APPLICATION

(11) **EP 1 267 397 A1**
(43) Date of publication of application: **18.12.2002**
(21) Application number: 01114141.3
(22) Date of filing: 11.06.2001
(51) Int. Cl.: H01L 21/60

(54) **Semiconductor device with self-aligned contact and method for manufacturing said device**

(71) Applicant: Infineon Technologies SC300 GmbH & Co. KG, 01099 Dresden (DE)
(72) Inventor: Zedlitz, Ralf, 01129 Dresden (DE); Spuler, Bruno, 81373 München (DE)
(74) Representative: Epping Hermann & Fischer

(57) **Abstract**

There is disclosed a semiconductor device and a method for manufacturing said semiconductor device with self-aligned contact. A first conductor (20) and a second conductor (25) are arranged on the surface (10) of the semiconductor substrate (5). The first conductor (20) and the second conductor (25) are encapsulated with a first encapsulation (30) and a second encapsulation (35), respectively. The first encapsulation and the second encapsulation comprise titanium oxide or boron nitride or silicon carbide or magnesium oxide or carbon. The first encapsulation (30) and the second encapsulation (35) are suitable as a self-aligning etch mask for etching a self-aligned contact hole between the first conductor (20) and the second conductor (25).

## Description

The present invention relates to a semiconductor device with a self-aligned contact and a method for manufacturing the semiconductor device with a self-aligned contact.

In the technical field of semiconductor devices, it is common and necessary to contact doped regions which are arranged in a semiconductor substrate. When two neighbouring word lines are arranged on a surface of the semiconductor substrate and a doped region is arranged in the semiconductor substrate between the two neighbouring word lines, it is known to encapsulate the word lines on their tops and side walls with a socalled liner as an etch resistant material to gain a self-aligned contact between the two word lines to the doped region.

The encapsulation for the word lines typically consists of silicon nitride, the word lines typically consist of doped poly silicon and an insulating layer covering the word lines and the substrate typically consists of silicon oxide. The etch selectivity between silicon oxide and silicon nitride is nowadays not sufficient for modern semiconductor devices. While etching the insulating layer consisting of silicon oxide with a roughly patterned resist mask, the encapsulation of the word lines directs the etching process self-aligned to the doped region between the neighbouring word lines. During this process the encapsulation of the word lines is etched as well and holes can be etched into the encapsulation resulting in the damage of the word line or a short-circuitry between the word line and the contact plug filled in between the two neighbouring word lines for contacting the doped region in the substrate.

The document US 5,792,703 describes a liner comprising aluminium oxide as an etch mask for a gate stack.

The document US 5,384,287 shows an additional silicon oxide layer between the poly silicon gate stack and the aluminium oxide liner.

In view of the prior art it is an objective of the present invention to provide a semiconductor device and a method for manufacturing the semiconductor device with a self-aligned contact which prevents shortcuts between neighbouring conductors and reduces capacitive coupling between neighbouring conductors.

This objective is solved by a semiconductor device comprising:
- a substrate with a surface;
- a first conductor arranged on the surface of the substrate, whereby the first conductor comprises a first top surface and a first side wall;
- a second conductor arranged on the surface of the substrate, whereby the second conductor comprises a second top surface and a second side wall and whereby the first conductor and the second conductor are arranged next to each other;
- a first encapsulation which is arranged on the first top surface and on the first side wall of the first conductor;
- a second encapsulation which is arranged on the second top surface and on the second side wall of the second conductor,
- characterised in that the first encapsulation or the second encapsulation comprise titanium oxide or boron nitride or silicon carbide or magnesium oxide or carbon in diamond like structure or carbon in amorphous structure.

The invented semiconductor device comprises an encapsulation for a conductor. The encapsulation comprises titanium oxide or boron nitride or silicon carbide or magnesium oxide or carbon in diamond like structure or carbon in amorphous structure. The mentioned materials have the advantage of a high etch selectivity compared to silicon oxide. This enables a self-aligned contact with the encapsulation as a self-aligning etch mask. Due to the high etch selectivity between the mentioned materials and silicon oxide, the encapsulation, namely the liner, can be built thinner while still providing the same etch resistivity as materials known from prior art. The thinner liner enables the first conductor or the second conductor or the contact plug between the first and the second conductor to be built with a larger cross-section area resulting in a lower resistance.

Another advantage of the invention is that a malfunction of the semiconductor device due to short circuitry between the first conductor or the second conductor with the contact plug can be avoided due to the improved etch resistivity of the new liner materials.

According to an embodiment of the present invention a third encapsulation is arranged on the first top surface and on the first side wall of the first conductor between the first conductor and the first encapsulation. The third encapsulation is arranged between the first conductor and the first encapsulation. The third encapsulation enables another material with a different dielectric constant to be arranged between the first conductor and a contact plug.

According to another embodiment of the present invention the first encapsulation comprises a first dielectric constant and the third encapsulation comprises a second dielectric constant, whereby the second dielectric constant is less then the first dielectric constant. This can reduce the capacitive coupling between the first conductor and a contact plug.

In a further embodiment of the present invention the third encapsulation comprises silicon oxide. Silicon oxide provides a dielectric constant of approximately 3.9, which can be used to reduce the capacitive coupling between the first conductor and the contact plug. In a preferred embodiment of the present invention a contact plug is arranged on the surface of the semiconductor substrate between the first conductor and the second conductor. The contact plug is capable of electrically contacting a doped region in the substrate, which is arranged between the first conductor and the second conductor while maintaining the isolation between the first conductor, the second conductor and the contact plug.

According to the method, the objective is solved by a method for manufacturing a semiconductor device with a self-aligned contact comprising the steps:
- providing a semiconductor substrate with a surface;
- arranging a first conductor on the surface of the substrate, whereby the first conductor comprises a first top surface and a first side wall;
- arranging a second conductor on the surface of the substrate, whereby the second conductor comprises a second top surface and a second side wall;
- arranging a first encapsulation on the first top surface and on the first side wall of the first conductor;
- arranging a second encapsulation on the second top surface and on the second side wall of the second conductor,
- characterized in that the first encapsulation or the second encapsulation comprise titanium oxide or boron nitride or silicon carbide or magnesium oxide or carbon in diamond like structure or carbon in amorphous structure.

According to an embodiment of the present invention the first conductor and the second conductor are arranged on the surface of the semiconductor before the first encapsulation and the second encapsulation are arranged on the conductors.

A further embodiment of the present invention comprises the step of etching a contact hole between the first conductor and the second conductor using the first encapsulation and the second encapsulation as a self-aligning etch mask. The contact hole is etched for receiving a contact plug. The self-aligning of the contact hole is enabled by the first encapsulation and the second encapsulation which directs the etching process - for etching the contact hole - between the first conductor and the second conductor towards the surface of the semiconductor. The first conductor and the second conductor are covered by the first encapsulation and the second encapsulation so that they are not etched.

In a further embodiment of the invention the step of filling a contact plug in the contact hole between the first conductor and the second conductor is performed. The contact plug is a self-aligned contact plug between the first conductor and the second conductor and is contacting a doped region which is arranged between the first conductor and the second conductor in the substrate.

Another embodiment of the invention comprises the step of arranging a third encapsulation on the first top surface and on the first side wall of the first conductor before the first encapsulation is arranged on the first conductor. This process step builds a third encapsulation between the first conductor and the first encapsulation. The third encapsulation can advantageously consist of a material with a low dielectric constant near 1. For example silicon oxide is suitable as a material for the third encapsulation providing a dielectric constant of roughly 3.9.

According to another embodiment of the invention the first encapsulation is deposited as a titanium layer and is oxidized in an oxygen-containing atmosphere to titanium oxide. This enables a process step for depositing a titanium layer, which is oxidized afterwards. Also a process step for depositing the first encapsulation or the second encapsulation or the third encapsulation with the desired stoichiometry is suitable to manufacture the inventive arrangement.

The invention will be better understood by reference to the following description of embodiments of the invention taken in conjunction with the accompanying drawings wherein
- Figure 1: shows a substrate with a first conductor and a second conductor which are encapsulated by the inventive encapsulation;
- Figure 2: shows a substrate with a first conductor and a second conductor which contain an additional encapsulation;
- Figure 3: shows a cross section of a semiconductor dynamic random access memory comprising a transistor and a trench capacitor.

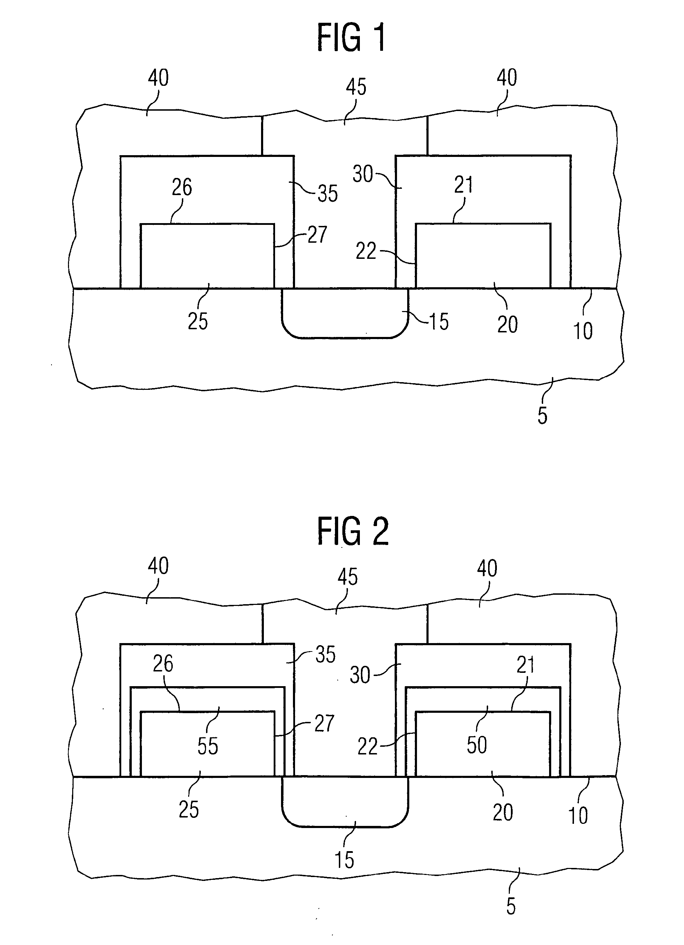

Figure 1 shows a semiconductor substrate 5 with a surface 10. On the surface 10 of the semiconductor substrate 5, a first conductor 20 and a second conductor 25 are arranged. The first conductor 20 comprises a first top surface 21 and a first side wall 22. The second conductor 25 comprises a second top surface 26 and a second side wall 27. The first conductor 20 and the second conductor 25 are separated from each other and a doped region is arranged in the substrate 5 between the first conductor 20 and the second conductor 25. The first conductor 20 is encapsulated with a first encapsulation 30, which is arranged on the first top surface 21 and the first side wall 22. The second conductor 25 is encapsulated by a second encapsulation 35, which is arranged on the second top surface 26 and the second side wall 27. The first encapsulation 30 and the second encapsulation 35 and the surface 10 of the substrate 5 are covered with an isolating layer 40. In the isolating layer 40, a contact hole is formed and the contact hole is filled with a contact plug 45. The contact plug 45 is arranged on top of a doped region 15, which is arranged between the first conductor 20 and the second conductor 25. For example the substrate 5 consists of silicon. The doped region 15 is a silicon doped region, doped with boron or phosphor or arsenide. The first conductor 20 and the second conductor 25 are a gate stack or a word line comprising doped silicon. In this case the first conductor and the second conductor are a first and a second conductor. The isolating layer 40 consists of a doped silicate glass such as phosphorous silicate glass, boron silicate glass or boron phosphorous silicate glass. The first encapsulation 30 and the second encapsulation 35 comprise titanium oxide or boron nitride or silicon carbide respectively. For example the thickness of the first encapsulation 30 is bigger on top of the first conductor 20 compared to the thickness of the first encapsulation 30 on the side wall of the first conductor 20. This is useful because the process for etching the contact hole for the contact plug 45 is a directed etch process which is performed roughly perpendicular to the surface 10 of the substrate 5. As a result, the etch attack of the first encapsulation 30 is greater for the part on top of the first conductor 20 compared to the part on the side walls of the first conductor 20.

According to Figure 2 another embodiment of the present invention is shown. Compared to Figure 1 an additional third encapsulation 50 is arranged between the first conductor 20 and the first encapsulation 30. Additionally a fourth encapsulation 55 is arranged on top and on the side walls of the second conductor 25 between the second conductor 25 and the second encapsulation 35. For example the third encapsulation 50 and the fourth encapsulation 55 consist of a material with a low dielectric constant near 1. For example silicon oxide with a dielectric constant of roughly 3.9 is suitable as a material for a third encapsulation 50 and the fourth encapsulation 55. The third encapsulation 50 and the fourth encapsulation 55 can reduce the electronic coupling between the first conductor 20 and the contact plug 45 or between the second conductor 25 and the contact plug 45. This is for example useful, when different electronic signals propagate on the first and the second electric conductor 20, 25.

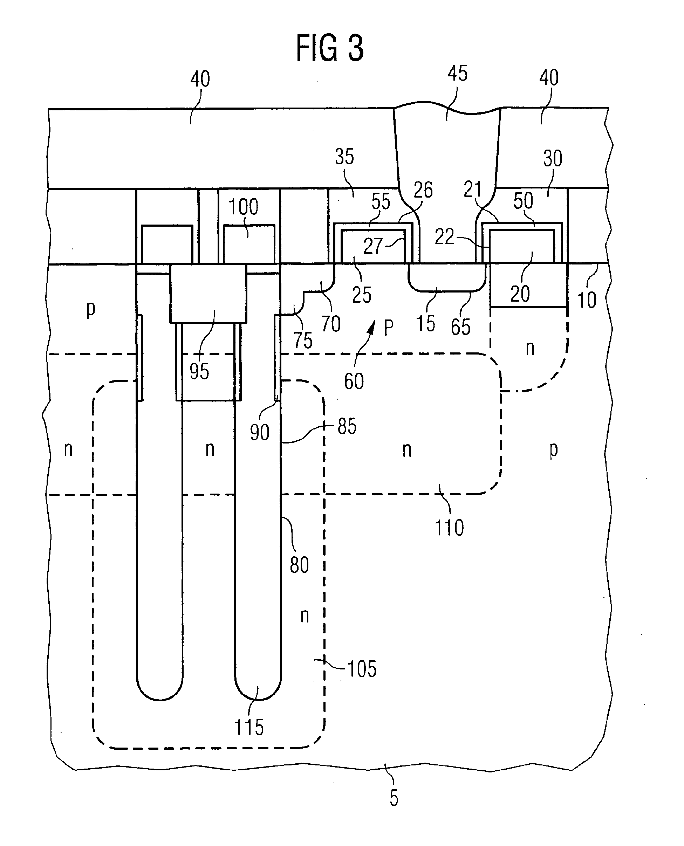

Figure 3 shows another embodiment of the invention as a cross section of a semiconductor dynamic random access memory (DRAM) comprising a transistor 60 and a capacitor 80. Figure 3 shows a substrate 5 with a surface 10. On the surface 10 a first conductor 20 with a first top surface 21 and with a first side wall 22 is arranged. A second conductor 25 is arranged on the surface 10. The second conductor 25 comprises a top surface 26 and a side wall 27. Between the first conductor 20 and the second conductor 25 a doped region 15 is arranged in the substrate 5.

For example the second conductor 25 is the gate electrode of a transistor 60, which is also comprising a first doped region 65 which is equivalent to the doped region 15 and the transistor 60 also comprises a second doped region 70 which is arranged in the substrate 5. For example a gate oxide is arranged between the substrate 5 and the second conductor 25 so that the second conductor 25 can act as gate electrode to control a current flowing from the first doped region 65 to the second doped region 70.

The second doped region 70 is connected to an out-diffusion 75 which is also arranged in the substrate 5. Next to the out-diffusion 75 a trench 85 is arranged in the substrate 5. In the trench 85 a trench capacitor 80 is arranged, which comprises an isolation collar 90. On top of the trench 85 a shallow trench isolation 95 is arranged. On top of the shallow trench isolation 95 a passing word line 100 is arranged.

The trench 85 is filled with a conducting trench fill 115 which is forming the inner electrode of the trench capacitor 80. The outer electrode of the trench capacitor 80 is arranged as a buried plate 105 in the substrate 5. The buried plate is for example a n-doped region. The n-doped regions of neighbouring trench capacitors are connected together with a buried layer 110 which is arranged as an n-doped layer in the substrate 5. The substrate 5 for example is comprising p-doped silicon.

Between the first encapsulation 30 and the first conductor 20 a third encapsulation 50 is arranged. Between the second conductor 25 and the second encapsulation 35 a fourth encapsulation 55 is arranged. On top of the first encapsulation 30 and the second encapsulation 35 an isolation layer 40 is arranged. A contact plug 45 is arranged on top of the doped region 15 to contact the doped region 15. The contact plug 45 for example is capable of building an electric contact between the doped region 15 and a bit line which can be arranged on the isolation layer 40.

## Claims

1. A semiconductor device comprising:
- a substrate (5) with a surface (10);
- a first conductor (20) arranged on the surface (10) of the substrate (5), whereby the first conductor (20) comprises a first top surface (21) and a first side wall (22) ;
- a second conductor (25) arranged on the surface (10) of the substrate (5), whereby the second conductor (25) comprises a second top surface (26) and a second side wall (27) and whereby the first conductor (20) and the second conductor (25) are arranged next to each other;
- a first encapsulation (30) which is arranged on the first top surface (21) and on the first side wall (22) of the first conductor (20) ;
- a second encapsulation (35) which is arranged on the second top surface (26) and on the second side wall (27) of the second conductor (25),
**characterised in that**
the first encapsulation (30) or the second encapsulation (35) comprise titanium oxide or boron nitride or silicon carbide or magnesium oxide or carbon in diamond like structure or carbon in amorphous structure.

2. Semiconductor device according to Claim 1,
**characterised in that**
a third encapsulation (50) is arranged on the first top surface (21) and on the first side wall (22) of the first conductor (20) between the first conductor (20) and the first encapsulation (30).

3. Semiconductor device according to Claim 2,
**characterised in that**
the first encapsulation (30) comprises a first dielectric constant and the third encapsulation comprises a second dielectric constant, whereby the second dielectric constant is less then the first dielectric constant.

4. Semiconductor device according to one of the Claims 2 or 3,
**characterised in that**
the third encapsulation (50) comprises silicon oxide.

5. Semiconductor device according to one of the Claims 1 to 4,
**characterised in that**
a contact plug (45) is arranged on the surface (10) of the semiconductor substrate (5) between the first conductor (20) and the second conductor (25).

6. Method for manufacturing a semiconductor device with a self-aligned contact comprising the steps:
- providing a semiconductor substrate (5) with a surface (10) ;
- arranging a first conductor (20) on the surface (10) of the substrate (5), whereby the first conductor (20) comprises a first top surface (21) and a first side wall (22) ;
- arranging a second conductor (25) on the surface (10) of the substrate (5), whereby the second conductor (25) comprises a second top surface (26) and a second side wall (27);
- arranging a first encapsulation (30) on the first top surface (21) and on the first side wall (22) of the first conductor (20) ;
- arranging a second encapsulation (35) on the second top surface (26) and on the second side wall (27) of the second conductor (25),
**characterized in that**
the first encapsulation (30) or the second encapsulation (35) comprise titanium oxide or boron nitride or silicon carbide or magnesium oxide or carbon in diamond like structure or carbon in amorphous structure.

7. Method according to Claim 6,
**comprising the step of**
etching a contact hole between the first conductor (20) and the second conductor (25) using the first encapsulation (30) and the second encapsulation (35) as a self-aligning etch mask.

8. Method according to Claim 7,
**comprising the step of**
filling a contact plug (45) in the contact hole between the first conductor (20) and the second conductor (25).

9. Method according to one of the Claims 6 to 8, **comprising the step of**
arranging a third encapsulation (50) on the first top surface (21) and on the first side wall (22) of the first conductor (20) before the first encapsulation (30) is arranged on the first conductor (20).

10. Method according to one of the Claims 6 to 9,
**characterised in that**
the first encapsulation (30) is deposited as a titanium layer and is oxidized in an oxygen containing atmosphere to consist of titanium oxide.
